(19)

**Europäisches Patentamt**
**European Patent Office**
**Office européen des brevets**

(11)  **EP 4 213 172 B1**

(12)  **EUROPEAN PATENT SPECIFICATION**

(45) Date of publication and mention
of the grant of the patent:
**11.03.2026 Bulletin 2026/11**

(21) Application number: **22210601.5**

(22) Date of filing: **30.11.2022**

(51) International Patent Classification (IPC):
*H01G 11/14* (2013.01)    *H01G 11/08* (2013.01)
*H01G 11/58* (2013.01)    *H01M 10/42* (2006.01)
*H01M 10/48* (2006.01)    *H01M 50/213* (2021.01)
*H01M 50/284* (2021.01)    *G01M 3/16* (2006.01)
*G01R 31/36* (2020.01)    *G01R 31/392* (2019.01)
*H01G 11/10* (2013.01)    *G01M 3/18* (2006.01)
*G01R 31/52* (2020.01)    *H01G 11/78* (2013.01)
*G01R 31/389* (2019.01)

(52) Cooperative Patent Classification (CPC):
H01M 10/48; G01M 3/165; G01M 3/186;
G01R 31/392; G01R 31/52; H01G 11/08;
H01G 11/10; H01G 11/14; H01G 11/58;
H01M 10/4207; H01M 10/4228; H01M 10/425;
H01M 10/4285; H01M 10/482; H01M 10/484;

(Cont.)

(54) **LEAKAGE DETECTION IN ENERGY STORAGE MODULES AND ASSOCIATED DEVICES AND METHODS**

LECKDETEKTION IN ENERGIESPEICHERMODULEN UND ZUGEHÖRIGE VORRICHTUNGEN UND VERFAHREN

DÉTECTION DE FUITE DANS DES MODULES DE STOCKAGE D'ÉNERGIE ET DISPOSITIFS ET PROCÉDÉS ASSOCIÉS

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **13.01.2022 DE 102022100730**

(43) Date of publication of application:
**19.07.2023 Bulletin 2023/29**

(73) Proprietor: **Skeleton Technologies GmbH**
**04420 Markranstädt (DE)**

(72) Inventor: **PILLE, Siim**
**01900 Großröhrsdorf (DE)**

(74) Representative: **KASTEL Patentanwälte PartG mbB**
**St.-Cajetan-Straße 41**
**81669 München (DE)**

(56) References cited:
JP-A- 2012 226 866    US-A1- 2007 190 403
US-A1- 2013 154 652    US-A1- 2019 369 153
US-A1- 2020 280 108

**(Cont. next page)**

(52) Cooperative Patent Classification (CPC): (Cont.)
**H01M 50/213; H01M 50/284;** G01R 31/389;
H01G 11/78; H01M 2010/4271

## Description

The invention relates to a leakage sensor arrangement. The invention further relates to energy storage modules using said leakage sensor arrangement and methods for detecting and locating electrolyte leakage.

Modern energy storage modules usually rely on advanced battery technology, such as lithium ion batteries, or may employ ultracapacitors. Both types of energy storage use electrolyte. During production the cells are tested for leakage of said electrolyte. Leaked electrolyte is problematic since it usually indicates an imminent failure, possible catastrophic failure, of the leaking cell.

EP 1 675 210 B1 discloses a manufacturing method of a battery comprising an adhering process to adhere fluorescent material (leakage indicator including fluorescein) which emits fluorescence in response to ultraviolet radiation irradiated under condition that electrolyte exists, to at least one portion of a surface on a battery case, and a leakage detecting process to detect presence/absence of electrolyte leakage with fluorescence which an adhered portion emits in response to the ultraviolet radiation irradiated on at least the adhered portion which has adhesion of the fluorescent material, out of the surface on the battery case.

US 9 267 993 B2 discloses a system for monitoring parameters of an energy storage system having a multiplicity of individual energy storage cells. A radio frequency identification and sensor unit is connected to each of the individual energy storage cells. The radio frequency identification and sensor unit operates to sense the parameter of each individual energy storage cell and provides radio frequency transmission of the parameters of each individual energy storage cell. A management system monitors the radio frequency transmissions from the radio frequency identification and sensor units for monitoring the parameters of the energy storage system.

US 9 869 726 B2 discloses a battery management system using a sensor inside of the battery that sensor enables monitoring and detection of various events in the battery and transmission of a signal from the sensor through the battery casing to a control and data acquisition module by wireless transmission. The detection of threshold events in the battery enables remedial action to be taken to avoid catastrophic events.

US 2007 / 0 190 403 A1 discloses a device for detecting electrolyte overflow.

US 2019 / 0 369 153 A1 discloses leakage detection on a printed circuit board by interleaved conductive traces.

It is the object of the invention to improve energy storage management systems, preferably with regard to production efficiency and operational safety.

It should be noted that any enumeration is for clarity only and does not imply a specific sequence of operations.

The invention according to claim 1 provides a leakage sensor arrangement configured for detecting leaking of an electrolyte out of an energy storage cell, the leakage sensor arrangement comprising:

- an energy storage cell including an electrolyte;
- a substrate;
- at least one monitoring portion that is arranged on the substrate so as to be capable to interact with emanating electrolyte from the energy storage cell by means of impedance; and
- an evaluation unit that is operatively coupled to the monitoring portion and configured for measuring an impedance value of the monitoring portion and for determining the presence of emanating electrolyte from the energy storage cell due to an impedance change between a predetermined impedance value and a measured impedance value or between at least two measured impedance values, wherein the monitoring portion includes at least one coil-like sensor member that is operatively coupled to the evaluation unit.

Preferably, the energy storage cell is an ultracapacitor or a hybrid ultracapacitor. Preferably, the substrate is a circuit board, such as a printed circuit board.

Preferably, the energy storage cell is arranged within a boundary of the monitoring portion.

Preferably, the energy storage cell is arranged on one side of the substrate and the monitoring portion is arranged on the same side. Preferably, the energy storage cell is arranged on one side of the substrate and the monitoring portion is arranged on an opposite side. Preferably, the energy storage cell is arranged on one side of the substrate and the monitoring portion is arranged between the one side and the opposite side within the substrate.

Preferably, the sensor member is formed by a conducting path on or within the substrate.

The invention according to claim 7 provides an energy storage module for storing electrical energy, the energy storage module comprising:

- a plurality of energy storage cells, at least one including an electrolyte;
- an energy storage cell management system configured for managing charging and discharging of the energy storage cells; and
- a leakage sensor arrangement according to any of claims 1 to 6.

Preferably, energy storage cell management system comprises the evaluation unit.

Preferably, the leakage sensor arrangement includes a plurality of monitoring portions, wherein each energy storage cell that includes an electrolyte is arranged to be monitored by a monitoring portion, and each monitoring portion is operatively coupled to the evaluation unit.

The invention according to claim 10 provides a method for operating a leakage sensor arrangement, the method comprising:

a) the evaluation unit continuously or periodically measuring an impedance value for each monitoring portion by applying an alternating current to the monitoring portion for generating a primary magnetic field by at least one coil-like sensor member of the monitoring portion;

b) the evaluation unit determining an impedance change value based on a predetermined impedance value and a measured impedance value and/or based on at least two measured impedance values that were measured at different points in time for the same monitoring portion; and

c) the evaluation unit determining the presence of an electrolyte leakage, if the impedance change value exceeds a predetermined threshold, and generating a leak signal that indicates presence of electrolyte leakage.

Preferably, the method comprises generating a secondary magnetic field within leaked electrolyte that is in the vicinity of the monitoring portion, the secondary magnetic field causing a change of the impedance value of the sensor member.

The invention according to claim 12 provides a method for locating an electrolyte leakage of an electrolyte out of an energy storage cell within a preferred energy storage module, the method comprising:

a) defining a plurality of monitoring portions each including at least one coil-like sensor member and the evaluation unit storing an association of each monitoring portion with a particular location within the energy storage module;

b) performing a previously described method for operating a leakage sensor arrangement; and

c) upon the evaluation unit determining the presence of any leakage, also determining the monitoring portion in which the leakage was determined to be present and generating a leakage signal that is indicative of the presence and location of the leakage.

Preferably, the leakage signal causes the management system to shut down the energy storage module. Preferably, the leakage signal causes the management system to electrically remove or isolate the affected energy storage cell from the remaining circuit. Preferably, the leakage signal causes the management system to controlledly discharge the affected energy storage cell. Preferably, the leakage signal causes the management system to initiate fire mitigation or extinguishing measures.

Compared to known monitoring systems, the ideas disclosed herein allow for a simpler configuration. The evaluation unit causes the monitoring portion to send out a magnetic field that induces eddy currents in the electrolyte, if it is present on the monitoring portion. The induced eddy currents reinduce a secondary magnetic field, which changes the reflected impedance of the sensor. The properties of the secondary magnetic field, such as size and orientation, depend on the distribution of electrolyte.

Considering that the reinduced field affects the primary one, a single sensor can monitor the impedance within the monitoring portion using the so-called reflected impedance of the sensor member. Employing a traditional transformer model with mutual inductance $M_{12}$ the complex reflected sensor member impedance Z can be expressed by the subsequent equation:

$$Z = R + j\omega L - \frac{\omega^3 C_{El} M_{12}^2}{j\omega C_{El}(R_{El} + j\omega L_{El}) + 1}$$

where R and L are the resistance and inductance of the sensor member, $R_{El}$, $C_{El}$ and $L_{El}$ are the resistance, capacitance and inductance of the electrolyte, $\omega$ is the frequency of the energizing current and $j$ is the imaginary unit.

By using impedance as a measurement principle, the sensitivity is more or less independent of the specific electrolyte used in the storage cells. Rather, the sensitivity depends on the magnetic properties of the electrolyte, which are similar for different electrolytes and usually determined by the amount of conductive ions within the electrolyte.

Leakage of electrolyte may be accompanied by decomposition of the electrolyte into different molecules, one of which is hydrogen. Hydrogen is rather difficult to detect reliably due to its high diffusion rate, however, it is a major explosive hazard, since it may form explosive mixtures with air over a large range of concentration.

Ideally, the ideas described herein allow activation of counter-measures or mitigation systems well before decomposition occurs, as soon as the electrolyte leaves the cell. Counter-measures may be a controlled shutdown of the module or electrical isolation and controlled discharge of the affected cell. As a mitigation inert gas, such as nitrogen, may be flooded towards the affected cell in order to dilute flammable gases below explosion threshold or extinguish any flames. Consequently, catastrophic failures can be prevented more effectively.

The system allows monitoring of individual cells and thereby locating a particular defective cell within a large system with ease. The sensors may be integrated into the circuit boards so that a re-design of the modules, and as a result of this the manufacturing line, can be avoided.

Embodiments of the invention are described in more detail with reference to the accompanying schematic drawings that are listed below

Fig. 1    depicts an embodiment of an energy storage bank;

Fig. 2    depicts a side view of an energy storage module

Fig. 3    depicts a top view of the energy storage module of Fig. 2;

Fig. 4    depicts the operation of the leakage sensor arrangement;

Fig. 5    depicts a top view of a variant of the energy storage module of Fig. 2;

Fig. 6    depicts a side view of another energy storage module; and

Fig. 7    depicts a top view of the energy storage module of Fig. 6.

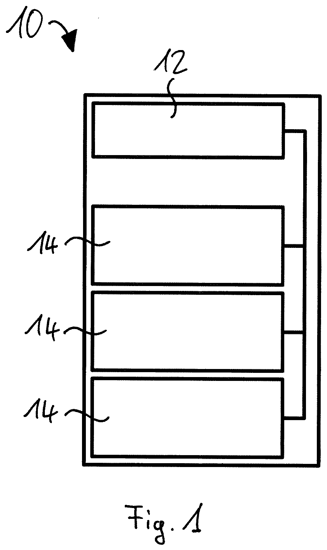

Referring to Fig. 1 an energy storage bank 10 includes a bank control module 12 that controls a plurality of energy storage modules 14. The energy storage bank 10 may be functioning as an uninterruptable power supply (UPS). The bank control module 12 mainly controls the UPS function of the energy storage bank 10, but may also be involved in controlling charging and/or discharging of each energy storage module 14.

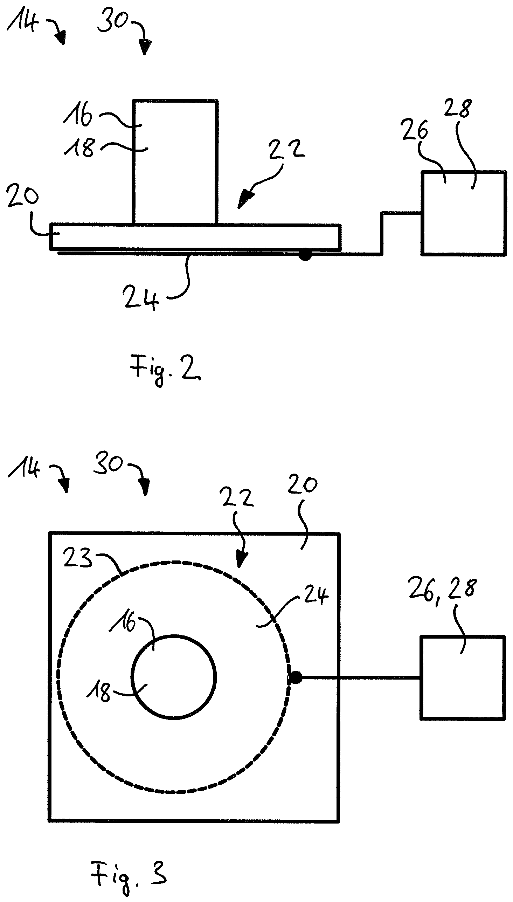

Referring to Fig. 2 and Fig. 3, at least one of the energy storage modules 14 comprises an energy storage cell 16. The energy storage cell 16 is preferably an (hybrid) ultracapacitor 18 that includes an electrolyte.

The energy storage module 14 comprises a substrate 20, e.g. a circuit board. The substrate 20 supports the energy storage cell 16, and the energy storage cell 16 can be mounted to the substrate 20.

The energy storage module 14 comprises a monitoring portion 22, that is arranged on the substrate 20. In this example, the monitoring portion 22 is arranged on the opposite side of the energy storage cell 16. However, it should be noted that the monitoring portion 22 may be integrated into the substrate 20 or be arranged on the same side as the energy storage cell 16. As long as the monitoring portion 22 is capable of magnetically interaction with possibly spilled electrolyte, the detection is possible. As depicted in Fig. 2, the energy storage cell 16 is preferably arranged within the outer contour or boundary 23 of the monitoring portion 22, when viewed from the top.

The monitoring portion 22 includes a coil-like sensor member 24. The sensor member 24 is formed preferably by conducting paths on or in the substrate 20. The sensor member 24 preferably forms an electromagnetic coil. The sensor member 24 may be generally spirally shaped. The sensor member 24 defines the boundary 23 and is in this example depicted as a circular shape. It should be noted that it is possible that the sensor member 24 has different contours, such as elliptical, rectangular, square, and the like, as spatial constraints may require.

The energy storage module 14 comprises an evaluation unit 26 that is operatively coupled to the monitoring portion 22 and in particular to the sensor member 24. The evaluation unit 26 detects the impedance of the monitoring portion 22, specifically the sensor member 24, and possible impedance changes. The evaluation unit 26 determines based on the impedance change(s) the presence of electrolyte on the monitoring portion 22 and as a result electrolyte leakage from the affected energy storage cell 16.

The energy storage module 14 comprises an energy storage cell management system 28. The energy storage cell management system 28 manages charging/-discharging etc. of the energy storage cell 16. The energy storage cell management system 28 may also communicate with the bank control module 12.

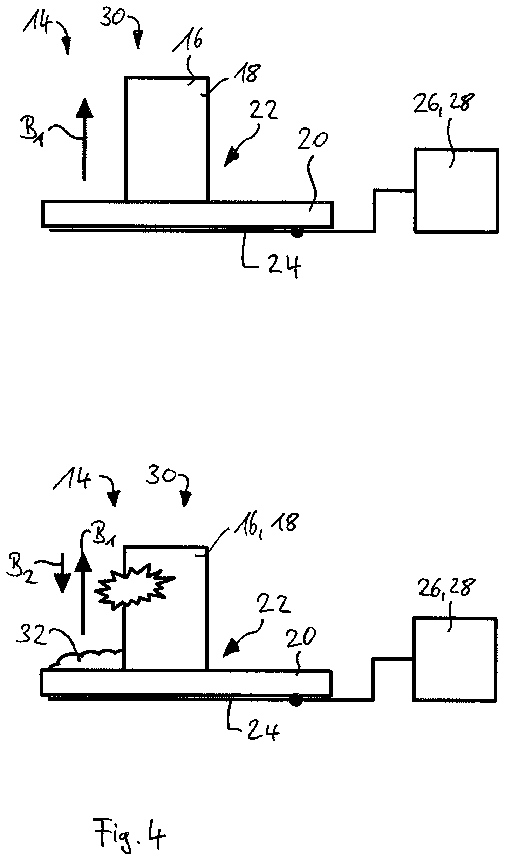

The energy storage cell 16, the substrate 20, the monitoring portion 22, and the evaluation unit 26 form a leakage sensor arrangement 30. Subsequently, the operation of the leakage sensor arrangement 30 is described in more detail with reference to Fig. 4.

As indicated in Fig. 4, top, the evaluation unit 26 supplies the sensor member 24 with an alternating current, which generates an alternating primary magnetic field $B_1$. The evaluation unit 26 may do this continuously or periodically. If no electrolyte is present, the evaluation unit 26 continuously or periodically measures the sensor member impedance value to be at a base value $Z_{base}$.

As depicted in Fig. 4, bottom, in case of electrolyte 32 leaking from the energy storage cell 16, the primary magnetic field $B_1$ induces a eddy currents in the electrolyte 32, said eddy currents generating a secondary magnetic field $B_2$ that has the opposite direction of the primary magnetic field $B_1$. The secondary magnetic field $B_2$ is also alternating and consequently induces eddy currents in the sensor member 24, which change the impedance value measured by the evaluation unit 26.

The evaluation unit 26 determines the amount of impedance value change $\Delta Z$ compared to the base value $Z_{base}$. If the impedance value change $\Delta Z$ exceeds a predetermined threshold, the evaluation unit 26 determines that electrolyte 32 is present on the substrate 20 and may generate a leakage signal which indicates a failure of the energy storage cell 16.

The energy storage cell management system 28, upon receipt of the leakage signal, may selectively initiate a shutdown of the energy storage module 14, electrically remove or isolate the affected energy storage cell 16 from the remaining circuit, and/or initiate fire mitigation or extinguishing measures, such as flooding the energy storage module 14 with an inert gas, e.g. nitrogen.

Subsequently further embodiments of the invention are only described insofar as they differ from the previously described embodiments.

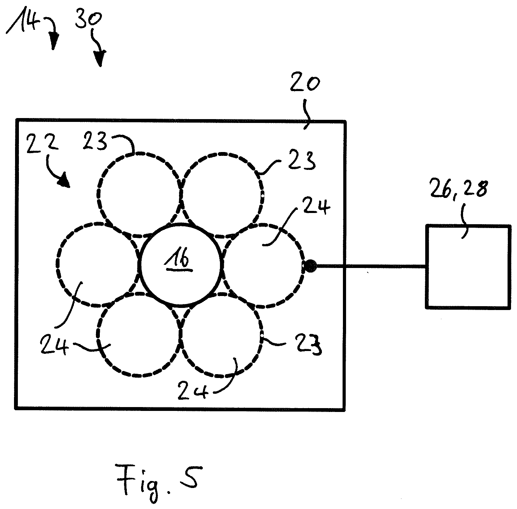

Referring to Fig. 5, the energy storage module 14 may comprise a monitoring portion 22 that has a plurality of sensor members 24. The sensor members 24 are distributed around the energy storage cell 16 to be monitored. The sensor members 24 may be individually coupled to the evaluation unit 16 or connected in series thereby functioning as a Base single sensor member 24.

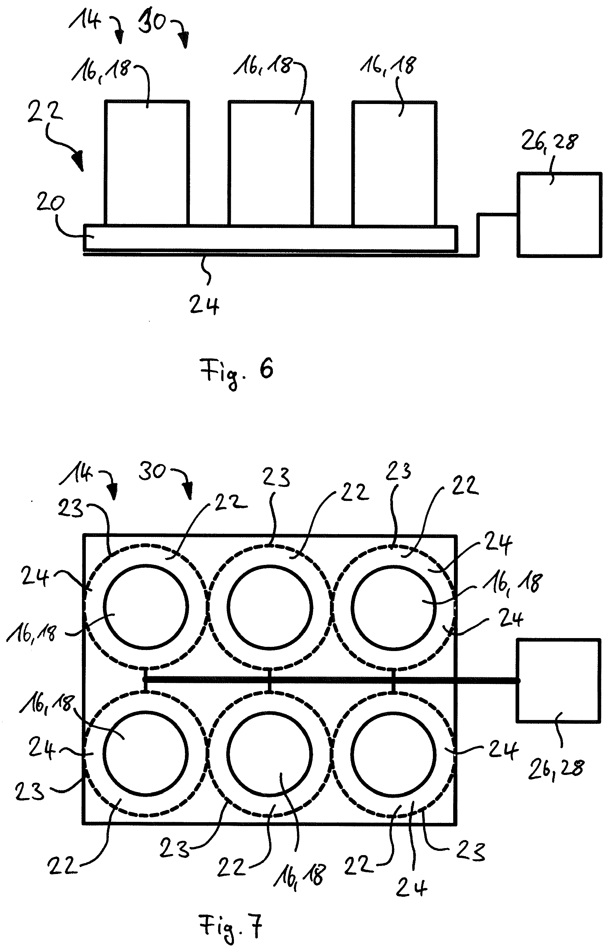

Referring to Fig. 6 and Fig. 7, the energy storage module 14 comprises a plurality of energy storage cells 16 that are arranged on the substrate 20. The energy storage module 14 comprises a plurality of monitoring portions 22 that are distributed on the substrate and defined such that each monitoring portion 22 is associated with at least one energy storage cell 16. The evaluation unit 26 is individually coupled to each monitoring portion 22 and can therefore, in addition to determining electrolyte leakage, determine which of the energy storage cells 16 is affected. This information is also included in the leakage signal. Consequently, the energy storage cell management system 28 can additionally identify the defective energy storage cell 16 and perform the previously described actions.

List of reference signs:

| 10 | energy storage bank |
| 12 | bank control module |
| 14 | energy storage module |
| 16 | energy storage cell |
| 18 | (hybrid) ultracapacitor |
| 20 | substrate |
| 22 | monitoring portion |
| 23 | boundary |
| 24 | sensor member |
| 26 | evaluation unit |
| 28 | energy storage cell management system |
| 30 | leakage sensor arrangement |
| 32 | electrolyte |

| $B_1$ | primary magnetic field |
| $B_2$ | secondary magnetic field |

**Claims**

1. Leakage sensor arrangement (30) configured for detecting leaking of an electrolyte (32) out of an energy storage cell (16), the leakage sensor arrangement (30) comprising:

   - an energy storage cell (16) including an electrolyte (32);
   - a substrate (20);
   - at least one monitoring portion (22) that is arranged on the substrate (20) so as to be capable to interact with emanating electrolyte (32) from the energy storage cell (16) by means of impedance; and
   - an evaluation unit (26) that is operatively coupled to the monitoring portion (22) and configured for measuring an impedance value of the monitoring portion (22),
   - wherein the evaluation unit (26) is configured for determining the presence of emanating electrolyte (32) from the energy storage cell (16) due to an impedance change between a predetermined impedance value ($Z_{base}$) and a measured impedance value (Z),

   **characterised in that**
   the monitoring portion (22) includes at least one coil-like sensor member (24) that is operatively coupled to the evaluation unit (26).

2. The arrangement (30) of claim 1, wherein the energy storage cell (16) is an ultracapacitor or a hybrid ultracapacitor (18).

3. The arrangement (30) of any of the preceding claims, wherein the substrate (20) is a circuit board, such as a printed circuit board.

4. The arrangement (30) of any of the preceding claims, wherein the energy storage cell (16) is arranged within a boundary (23) of the monitoring portion (22).

5. The arrangement (30) of any of the preceding claims, wherein the energy storage cell (16) is arranged on one side of the substrate (20) and the monitoring portion (22) is arranged on the same side, an opposite side, or between the one side and the opposite side within the substrate (20).

6. The arrangement (30) of any of the preceding claims, wherein the sensor member (24) is formed by a conducting path on or within the substrate (20).

7. An energy storage module (14) for storing electrical energy, the energy storage module (14) comprising:

   - a plurality of energy storage cells (16), at least one including an electrolyte (32);
   - an energy storage cell (16) management system configured for managing charging and discharging of the energy storage cells (16); and
   - a leakage sensor arrangement (30) according to any of the preceding claims.

8. The energy storage module (14) of claim 7, wherein energy storage cell management system (28) comprises the evaluation unit (26).

9. The energy storage module (14) of claim 7 or 8, wherein the leakage sensor arrangement (30) includes a plurality of monitoring portions (22), wherein each energy storage cell (16) that includes an electrolyte (32) is arranged to be monitored by a monitoring portion (22), and each monitoring portion (22) is operatively coupled to the evaluation unit (26).

**10.** A method for operating a leakage sensor arrangement (30) according to any of the claims 1 to 6, the method comprising:

a) the evaluation unit (26) continuously or periodically measuring an impedance value for each monitoring portion (22) by applying an alternating current to the monitoring portion (22) for generating a primary magnetic field ($B_1$) by at least one coil-like sensor member (24) of the monitoring portion (22);

b) the evaluation unit (26) determining an impedance change value based on a predetermined impedance value and a measured impedance value and/or based on at least two measured impedance values that were measured at different points in time for the same monitoring portion (22); and

c) the evaluation unit (26) determining the presence of an electrolyte leakage, if the impedance change value exceeds a predetermined threshold, and generating a leak signal that indicates presence of electrolyte leakage.

**11.** The method of claim 10, wherein the method comprises generating a secondary magnetic field ($B_2$) within leaked electrolyte (32) that is in the vicinity of the monitoring portion (22), the secondary magnetic field ($B_2$) causing a change of the impedance value of the sensor member (24).

**12.** A method for locating an electrolyte leakage of an electrolyte (32) out of an energy storage cell (16) within an energy storage module (14) according to any of the claims 7 to 9, the method comprising:

a) defining a plurality of monitoring portions (22) each including at least one coil-like sensor member (24) and the evaluation unit (26) storing an association of each monitoring portion (22) with a particular location within the energy storage module (14);

b) performing a method according to any of the claims 10 or 11; and

c) upon the evaluation unit (26) determining the presence of any leakage, also determining the monitoring portion (22) in which the leakage was determined to be present and generating a leakage signal that is indicative of the presence and location of the leakage.

**13.** The method of claim 12, wherein the leakage signal causes the management system (28) to shut down the energy storage module (14), and/or to electrically remove or isolate the affected energy storage cell (16) from the remaining circuit, and/or to controlledly discharge the affected energy storage cell (16), and/or to initiate fire mitigation or extinguishing measures.

**Patentansprüche**

**1.** Leckage-Sensoranordnung (30), die ausgebildet ist zum Detektieren einer Leckage eines Elektrolyten (32) aus einer Energiespeicherzelle (16), wobei die Leckage-Sensoranordnung (30) umfasst:

- eine Energiespeicherzelle (16), die einen Elektrolyten (32) enthält;
- ein Substrat (20);
- zumindest einen Überwachungsabschnitt (22), der auf dem Substrat (20) derart angeordnet ist, dass er mittels Impedanz mit einem aus der Energiespeicherzelle (16) ausströmenden Elektrolyten (32) interagieren kann, und
- eine Auswerteeinheit (26), die betrieblich mit dem Überwachungsbereich (22) verbunden ist und dazu ausgebildet ist, einen Impedanzwert des Überwachungsabschnitts (22) zu messen,
- wobei die Auswerteeinheit (26) dazu ausgebildet ist, das Vorliegen eines aus der Energiespeicherzelle (16) ausströmenden Elektrolyten (32) aufgrund einer Impedanzänderung zwischen einem vorgegebenen Impedanzwert ($Z_{base}$) und einem gemessenen Impedanzwert (Z) zu bestimmen,

**dadurch gekennzeichnet, dass**
der Überwachungsabschnitt (22) zumindest ein spulenförmiges Sensorelement (24) umfasst, das betriebsmäßig mit der Auswerteeinheit (26) verbunden ist.

**2.** Anordnung (30) nach Anspruch 1, wobei die Energiespeicherzelle (16) ein Ultrakondensator oder ein Hybrid-Ultrakondensator (18) ist.

**3.** Anordnung (30) nach einem der vorangehenden Ansprüche, wobei das Substrat (20) eine Leiterplatte ist, wie zum Beispiel eine gedruckte Schaltungsplatte.

**4.** Anordnung (30) nach einem der vorangehenden Ansprüche, wobei die Energiespeicherzelle (16) innerhalb einer Begrenzung (23) des Überwachungsabschnitts (22) angeordnet ist.

**5.** Anordnung (30) nach einem der vorangehenden Ansprüche, wobei die Energiespeicherzelle (16) auf einer Seite des Substrats (20) und der Überwachungsabschnitt (22) auf derselben Seite, auf einer gegenüberliegenden Seite oder zwischen der einen Seite und der gegenüberliegenden Seite in dem Substrat (20) angeordnet ist.

**6.** Anordnung (30) nach einem der vorangehenden Ansprüche, wobei das Sensorelement (24) durch eine Leiterbahn auf oder in dem Substrat (20) gebildet ist.

**7.** Energiespeichermodul (14) zum Speichern elektrischer Energie, wobei das Energiespeichermodul (14) umfasst:

- eine Mehrzahl von Energiespeicherzellen (16), von denen zumindest eine einen Elektrolyten (32) enthält;
- ein Managementsystem für die Energiespeicherzelle (16), das dazu eingerichtet ist, das Laden und Entladen der Energiespeicherzellen (16) zu verwalten; und
- eine Leckage-Sensoranordnung (30) gemäß einem der vorangehenden Ansprüche.

**8.** Energiespeichermodul (14) nach Anspruch 7, wobei das Energiespeicherzellen-Managementsystem (28) die Auswerteeinheit (26) umfasst.

**9.** Energiespeichermodul (14) nach Anspruch 7 oder 8, wobei die Leckage-Sensoranordnung (30) eine Mehrzahl von Überwachungsabschnitten (22) umfasst, wobei jede einen Elektrolyten (32) enthaltende Energiespeicherzelle (16) derart angeordnet ist, dass sie durch einen Überwachungsabschnitt (22) überwacht wird, und wobei jeder Überwachungsabschnitt (22) betrieblich mit der Auswerteeinheit (26) verbunden ist.

**10.** Verfahren für den Betrieb einer Leckage-Sensoranordnung (30) nach einem der Ansprüche 1 bis 6, wobei das Verfahren umfasst:

a) dass die Auswerteeinheit (26) den Impedanzwert für jeden Überwachungsabschnitt (22) kontinuierlich oder periodisch misst, indem an den Überwachungsabschnitt (22) ein Wechselstrom angelegt wird, um durch zumindest ein spulenförmiges Sensorelement (24) des Überwachungsabschnitts (22) ein primäres Magnetfeld ($B_1$) zu erzeugen;
b) dass die Auswerteeinheit (26) auf der Grundlage eines vorgegebenen Impedanzwerts und eines gemessenen Impedanzwerts und/oder auf der Grundlage von mindestens zwei gemessenen Impedanzwerten, die für denselben Überwachungsabschnitt (22) zu unterschiedlichen Zeiten gemessen wurden, einen Impedanzänderungswert bestimmt; und
c) dass die Auswerteeinheit (26) das Vorliegen einer Elektrolyt-Leckage bestimmt, wenn der Impedanzänderungswert einen vorgegebenen Schwellenwert übersteigt, und eine Leckagesignal erzeugt, das auf das Vorliegen einer Elektrolyt-Leckage hinweist.

**11.** Verfahren nach Anspruch 10, wobei das Verfahren das Erzeugen eines zweiten Magnetfelds ($B_2$) in dem ausströmenden Elektrolyten (32) umfasst, der sich in der Nähe des Überwachungsabschnitts (22) befindet, wobei das zweite Magnetfeld ($B_2$) eine Änderung des Impedanzwerts des Sensorelements (24) bewirkt.

**12.** Verfahren zum Auffinden einer Elektrolyt-Leckage eines Elektrolyten (32) aus einer Energiespeicherzelle (16) in einem Energiespeichermodul (14) nach einem der Ansprüche 7 bis 9, wobei das Verfahren umfasst:

a) Definieren einer Mehrzahl von Überwachungsabschnitten (22), die jeweils mindestens ein spulenförmiges Sensorelement (24) enthalten, und das Speichern einer Zuordnung jedes Überwachungsabschnitts (22) zu einer bestimmten Stelle in dem Energiespeichermodul (14) durch die Auswerteeinheit (26);
b) Durchführen eines Verfahrens nach einem der Ansprüche 10 oder 11; und
c) nachdem durch die Auswerteeinheit (26) bestimmt wurde, dass eine Leckage vorliegt, auch das Bestimmen des Überwachungsabschnitts (22), in dem die Leckage festgestellt wurde, und das Erzeugen eines Leckage-Signals, das auf das Vorliegen der Leckage und auf deren Stelle hinweist.

**13.** Verfahren nach Anspruch 12, wobei das Leckage-Signal das Managementsystem (28) veranlasst, das Energiespeichermodul (14) abzuschalten und/oder die betroffene Energiespeicherzelle (16) elektrisch zu entfernen und/oder von dem Reststromkreis zu isolieren und/oder die betroffene Energiespeicherzelle (16) kontrolliert zu entladen und/oder Brandminderungs- und/oder Löschmaßnahmen zu initiieren.

**Revendications**

**1.** Agencement de détection de fuite (30) conçu pour détecter une fuite d'électrolyte (32) provenant d'une cellule de stockage d'énergie (16), l'agencement de détection de fuite (30) comprenant:

- une cellule de stockage d'énergie (16) contenant un électrolyte (32);
- un substrat (20);
- au moins une section de surveillance (22) disposée sur le substrat (20) de manière à pouvoir interagir par impédance avec un électrolyte (32) s'écoulant de la cellule de stockage d'énergie (16); et

- une unité d'évaluation (26) qui est reliée de manière opérationnelle à la section de surveillance (22) et qui est conçue pour mesurer une valeur d'impédance de la section de surveillance (22),

- l'unité d'évaluation (26) étant conçue pour déterminer la présence d'un électrolyte (32) s'écoulant de la cellule de stockage d'énergie (16) sur la base d'une variation d'impédance entre une valeur d'impédance prédéfinie ($Z_{base}$) et une valeur d'impédance mesurée (Z),

**caractérisé en ce que**

la section de surveillance (22) comprend au moins un élément capteur en forme de bobine (24) qui est relié de manière opérationnelle à l'unité d'évaluation (26).

2. Agencement (30) selon la revendication 1, dans lequel la cellule de stockage d'énergie (16) est un supercondensateur ou un supercondensateur hybride (18).

3. Agencement (30) selon l'une quelconque des revendications précédentes, dans lequel le substrat (20) est un circuit imprimé, telle qu'une carte de circuit imprimé.

4. Agencement (30) selon l'une quelconque des revendications précédentes, dans lequel la cellule de stockage d'énergie (16) est disposée à l'intérieur d'une limite (23) de la section de surveillance (22).

5. Agencement (30) selon l'une quelconque des revendications précédentes, dans lequel la cellule de stockage d'énergie (16) est disposée sur un côté du substrat (20) et la section de surveillance (22) est disposée sur le même côté, sur un côté opposé ou entre le côté et le côté opposé dans le substrat (20).

6. Agencement (30) selon l'une quelconque des revendications précédentes, dans lequel l'élément capteur (24) est formé par une piste conductrice sur ou dans le substrat (20).

7. Module de stockage d'énergie (14) pour stocker de l'énergie électrique, le module de stockage d'énergie (14) comprenant:

- une pluralité de cellules de stockage d'énergie (16) dont au moins une contient un électrolyte (32);

- un système de gestion pour la cellule de stockage d'énergie (16) qui est conçu pour gérer la charge et la décharge des cellules de stockage d'énergie (16); et

- un agencement de détection de fuite (30) selon l'une des revendications précédentes.

8. Module de stockage d'énergie (14) selon la revendication 7, dans lequel le système de gestion des cellules de stockage d'énergie (28) comprend l'unité d'évaluation (26).

9. Module de stockage d'énergie (14) selon la revendication 7 ou 8, dans lequel l'agencement de détection de fuite (30) comprend une pluralité de sections de surveillance (22), chacune d'une cellule de stockage d'énergie (16) contenant un électrolyte (32) étant disposée de manière à être surveillée par une section de surveillance (22), et dans lequel chaque section de surveillance (22) est reliée de manière opérationnelle à l'unité d'évaluation (26).

10. Procédé pour faire fonctionner un dispositif de détection de fuite (30) selon l'une des revendications 1 à 6, le procédé comprenant:

a) que l'unité d'évaluation (26) mesure en continu ou périodiquement la valeur d'impédance pour chaque section de surveillance (22) en appliquant un courant alternatif à la section de surveillance (22) afin de générer un champ magnétique primaire ($B_1$) à travers au moins un élément capteur en forme de bobine (24) de la section de surveillance (22);
b) que l'unité d'évaluation (26) détermine une valeur de variation d'impédance sur la base d'une valeur d'impédance prédéfinie et d'une valeur d'impédance mesurée et/ou sur la base d'au moins deux valeurs d'impédance mesurées à des moments différents pour la même section de surveillance (22); et
c) que l'unité d'évaluation (26) détermine la présence d'une fuite d'électrolyte lorsque la valeur de variation d'impédance dépasse une valeur seuil prédéfinie et génère un signal de fuite indiquant la présence d'une fuite d'électrolyte.

11. Procédé selon la revendication 10, dans lequel le procédé comprend la génération d'un deuxième champ magnétique ($B_2$) dans l'électrolyte qui s'écoule (32) et qui se trouve à proximité de la section de surveillance (22), le deuxième champ magnétique ($B_2$) provoquant une modification de la valeur d'impédance de l'élément capteur (24).

12. Procédé pour détecter une fuite d'électrolyte (32) provenant d'une cellule de stockage d'énergie (16) dans un module de stockage d'énergie (14) selon l'une quelconque des revendications 7 à 9, le procédé comprenant:

a) définir une pluralité de sections de surveillance (22) contenant chacune au moins un élément capteur en forme de bobine (24) et stocker une attribution de chaque section de surveillance (22) à un emplacement déterminé dans le module de stockage d'énergie (14) par l'unité d'évaluation (26);
b) exécuter un procédé selon l'une quelconque des revendications 10 ou 11; et
c) après que l'unité d'évaluation (26) a déterminé qu'il y a une fuite, déterminer également la section de surveillance (22) dans laquelle la fuite a été détectée et générer un signal de fuite indiquant la présence de la fuite et son emplacement.

13. Procédé selon la revendication 12, dans lequel le signal de fuite amène le système de gestion (28) à désactiver le module de stockage d'énergie (14) et/ou à retirer électriquement la cellule de stockage d'énergie concernée (16) et/ou l'isoler du circuit électrique restant et/ou décharger de manière contrôlée la cellule de stockage d'énergie concernée (16) et/ou déclencher des mesures de réduction des risques d'incendie et/ou d'extinction.

10

12

14

14

14

Fig. 1

Fig. 2

Fig. 3

Fig. 4

Fig. 5

Fig. 6

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1675210 B1
- US 9267993 B2
- US 9869726 B2
- US 20070190403 A1
- US 20190369153 A1